# EUROPEAN PATENT APPLICATION

(11) **EP 1 182 278 A2**
(43) Date of publication of application: **27.02.2002**
(21) Application number: 01306149.4
(22) Date of filing: 17.07.2001
(51) Int. Cl.: C25D 1/10, C25D 3/38, H05K 3/38

(54) **Manufacturing method of electrodeposited copper foil and electrodeposited copper foil**

(30) Priority: 04.08.2000 JP 2000237405
(71) Applicant: Mitsui Mining & Smelting Co., Ltd, Tokyo (JP)
(72) Inventor: Takahashi, Naotomi, Mitsui Mining/Smelting Co. Ltd, Ageo-shi, Saitama (JP); Hirasawa, Yutaka, Mitsui Mining/Smelting Co. Ltd, Ageo-shi, Saitama (JP)
(74) Representative: Calamita, Roberto

(57) **Abstract**

A process for producing an electrodeposited copper foil, comprising the steps of: preparing an electrolyte having a copper concentration of 60 to 85 g/lit., a free sulfuric acid concentration of 100 to 250 g/lit., a chloride (Cl) ion concentration of 1 to 3 ppm and a gelatin additive concentration of 0.3 to 5 ppm and electrolyzing at 40 to 60°C and at a current density of 30 to 75 A/dm² to thereby electrodeposit a copper foil. The obtained electrodeposited copper foil is excellent in tensile strength and elongation.

An electrodeposited copper foil comprising: twins with fine crystals and/or columnar crystals, and chlorine (or chloride ion) incorporated in the twins so that the chlorine content of the electrodeposited copper foil is in the range of 50 ppm to 180 ppm, and 40 to 150 times that of chloride ion concentration in the electrolyte.

## Description

### FIELD OF THE INVENTION

The present invention relates to an electrodeposited copper foil having a satisfactory elongation and a very high tensile strength and a manufacturing method of such an electrodeposited copper foil. Further, the present invention relates to a copper-clad laminate produced using such an electrodeposited copper foil and a printed wiring board produced using such an electrodeposited copper foil.

### BACKGROUND OF THE INVENTION

In the continuous production of an electrodeposited copper foil, it is common practice to arrange a Ti-made cylindrical drum as a cathode and, opposite thereto, an insoluble anode in an electroforming cell filled with an electrolyte in which, for example, acidic copper sulfate is dissolved and electrodepositing copper on the surface of the cylindrical drum.

Printed wiring boards are produced from the thus obtained electrodeposited copper foil by laminating the same to a substrate such as an epoxy resin and thereafter forming printed circuits by etching, etc.

In recent years, electronic equipment is being miniaturized and densified, and, accordingly, the formation of electronic circuits of high density is being demanded. Therefore, multilayer printed wiring boards laminates each composed of a plurality of printed wiring boards bonded to each other are now being widely employed.

The manufacturing method of such printed circuit board generally includes a step of mounting devices on a wiring board by floating on melting solder at around 260°C. In this step, when the high-temperature elongation (HTE) of the copper foil is small, it has been experienced that, because of the difference in coefficient of thermal expansion (CTE) between the substrate and the copper foil, the copper foil cannot follow the expansion of the substrate with the unfavorable result that the copper foil is cracked to thereby cause electrical contact failure. Therefore, the copper foil with high tensile strength and large elongation at a high temperature is desired.

It is known that the above copper foil with large elongation can be provided by reducing the amount of impurities contained in the copper foil to thereby enhance the re-crystallinity of copper.

For example, Japanese Patent Application Publication (Unexamined) No. Hei 7-188969 discloses a manufacturing method of a substantially uniform electrodeposited copper foil with fine crystals of not more than 10 µm of diameter, and having random orientation, which method comprises electrolyzing an electrolyte containing copper ions, sulfate ions and at least one organic additives and having a chloride ion concentration adjusted to less than 1 ppm at a current density of 0.1 to 5 A/cm² to electrodeposited copper foil.

However, the copper foil produced by this method has a drawback in that the high-temperature elongation of the copper foil is not satisfactory. Moreover, because the chloride concentration of the electrolyte must be adjusted to less than 1 ppm, the process control is difficult and avoiding contamination of chloride from, for example, raw materials is extremely laborious. Further, when the chloride concentration of the electrolyte is out of the control range during the continuous operation, returning to within the control range takes a long time and thereby renders the production efficiency poor.

It has been proposed to obtain a copper foil with high tensile strength and large elongation by controlling the amount of chloride contained in the copper foil so as to adjust within a specified range.

For example, Japanese Patent Application Publication (Unexamined) No. Hei 10-36992 discloses an electrodeposited copper foil having a chloride content of up to 40 ppm and a sulfur content of up to 30 ppm, which electrodeposited copper foil exhibits an elongation of 5% or more at 180°C. The Japanese Patent Application Publication (Unexamined) No. Hei 10-36992 describes the use of an electrolyte composed of a copper sulfate solution acidified by sulfuric acid containing 5 ppm or less of chloride ions and 0.5 to 2 ppm of thiourea in the process for producing the above electrodeposited copper foil.

However, thiourea and the like are added as additives in the production of the electrodeposited copper foil, so that a high cost is involved. Further, the elongation of the electrodeposited copper foil has not always been satisfactory.

Further, Japanese Patent Application Publication (Unexamined) No. Hei 10-330983 discloses an electrodeposited copper foil containing 80 to 400 ppm of chloride, whose Vickers hardness ranges from 180 to 320 at 25°C and is 150 or more after heat treatment at 220°C for 30 min. The Japanese Patent Application Publication (Unexamined) No. Hei 10-330983 describes the use of a copper sulfate electrolyte acidified by sulfuric acid containing 50 to 250 mg/lit. of a chloride, 0.1 to 1.0 g/lit. of an oxyethylene surfactant, 1 to 10 mg/lit. of glue or gelatin and 1 to 10 mg/lit. of a nitrogenous organic compound in the process for producing the above electrodeposited copper foil.

However, a large amount of chloride must be added in the above disclosed production of the electrodeposited copper foil, so that there is the danger of corrosion of the apparatus used in the production. Moreover, the crystals of the obtained electrodeposited copper foil are columnar, so that the copper foil properties such as tensile strength and elongation are not always satisfactory.

With a view toward solving these problems, the inventors have made extensive and intensive studies. As a result, it has been found that the electrodeposited copper foil produced by electrolyzing an electrolyte having a chloride (Cl) ion concentration of 1 to 3 ppm, a copper concentration of 60 to 85 g/lit., a free sulfuric acid concentration of 100 to 250 g/lit. and a gelatin additive concentration of 0.3 to 5 ppm at 40 to 60 °C and at a current density of 30 to 75 A/dm², contains a high proportion of twins in which, especially at the twin boundary, chloride is selectively incorporated. Further, it has been found that the obtained electrodeposited copper foil has a chloride content of 50 to 180 ppm, and 40 to 150 times that of chloride ion concentration in the electrolyte, and is excellent in properties such as tensile strength and elongation. The present invention has been completed on the basis of these findings.

### OBJECT OF THE INVENTION

The present invention provides an electrodeposited copper foil which is excellent in tensile strength and elongation.

The present invention also provides a process for producing such a foil.

The present invention further provides a copper-clad laminate comprising an insulating substrate and such a foil which is laminated on the surface of the substrate and provides a printed wiring board furnished with a desirable wiring pattern, which is produced from such a foil.

### SUMMARY OF THE INVENTION

The process for producing an electrodeposited copper foil of the present invention comprises the steps of:
preparing an electrolyte having a copper concentration of 60 to 85 g/lit., a free H₂SO₄ (sulfuric acid) concentration of 100 to 250 g/lit., a chloride (Cl) ion concentration of 1 to 3 ppm and a gelatin additive concentration of 0.3 to 5 ppm, and
electrolyzing at 40 to 60°C and at a current density of 30 to 75 A/dm² to thereby electrodeposit a copper foil.

The electrodeposited copper foil of the present invention comprises:
twins with
fine crystals and/or columnar crystals,
chlorine (chloride ion) incorporated in the twin boundaries so that the chlorine content of the electrodeposited copper foil is in the range of 50 ppm to 180 ppm, and 40 to 150 times that of chloride ion concentration in the electrolyte.

A copper-clad laminate comprises an insulating substrate having at least one side thereof laminated with the above electrodeposited copper foil.

A printed wiring board furnished with desirable wiring pattern, produced by etching at its electrodeposited copper foil on a copper-clad laminate comprises an insulating substrate having at least one side thereof laminated with the above electrodeposited copper foil.

### BRIEF DESCRIPTION OF THE DRAWING

Fig. 1 shows a schematic cross-sectional view of a copper foil containing twins;
Fig. 2 shows an enlarged schematic view of twin boundary;
Fig. 3 is a schematic cross-sectional view of a copper foil comprising columnar crystals;
Fig. 4 is a schematic cross-sectional view of a copper foil comprising fine crystals;
Fig. 5 shows one example form of apparatus for use in the process for producing an electrodeposited copper foil according to the present invention; and
Fig. 6 (a) to (d) are photographs of a copper foil profile of the present invention and that of comparative examples by a scanning electron microscope (SEM).

### DETAILED DESCRIPTION OF THE INVENTION

The process for producing the electrodeposited copper foil, the electrodeposited copper foil, copper-clad laminate and the printed wiring board according to the present invention will be described in detail below.

### Process for Producing Electrodeposited Copper Foil

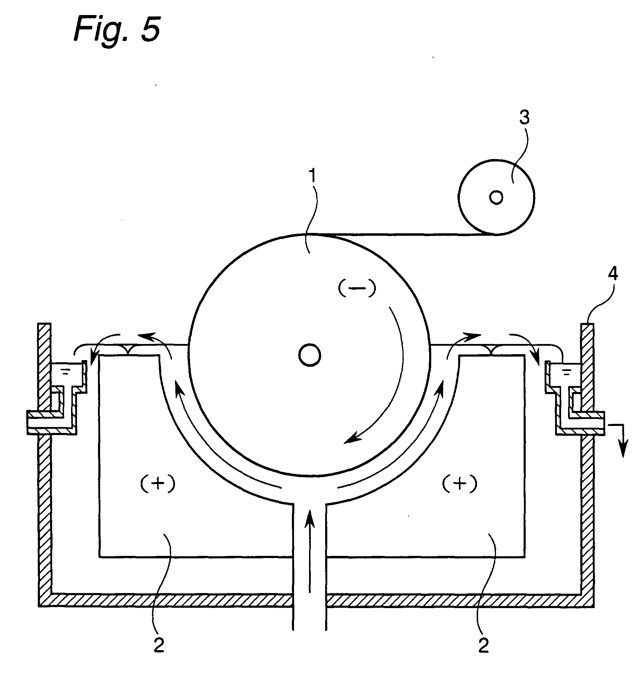

Fig. 5 shows one example form of apparatus useful in the process for producing the electrodeposited copper foil according to the present invention. In electroforming cell 4, an electrolyte containing copper sulfate is charged between cylindrical cathode drum 1 and anode 2 arranged along the cathode drum 1 with approximately a fixed gap held therebetween. Current for copper electrodeposition is supplied, so that copper is electrodeposited on the surface of the rotating cathode drum 1. The copper foil whose thickness has reached a given value is continuously released from the cathode drum 1 and wound round roll winder 3.

Generally, the cathode drum side of the obtained electrodeposited copper foil shows a shiny surface (glossy surface) while the electrodeposition side of the electrodeposited copper foil shows a matte surface (rough surface).

In the present invention, an electrolyte having a copper concentration of 60 to 85 g/lit., preferably 60 to 80 g/lit., and a sulfuric acid concentration of 100 to 250 g/lit., preferably 120 to 250 g/lit. is used.

In this electrolyte, chloride (Cl) ions are contained in a concentration of 1 to 3 ppm, preferably 1.0 to 2.5 ppm, more preferably 1.1 to 2.5 ppm. In the present invention, because chloride is incorporated in the copper foil in a large amount (4 to 20 times that of conventional electrodeposited copper foil), it may be required to add chloride. Generally, a chloride compound such as copper chloride is added. However, chloride (Cl) ions are contaminated from water or other raw materials added in the process for producing the copper foil, so that it may not be required to add a chloride compound to the electrolyte.

Further, 0.3 to 5 ppm, preferably 0.3 to 3 ppm of a gelatin additive is added to the electrolyte in the present invention. Examples of the gelatin additives and the like include glue and gelatin. When these gelatin additives are used in low chloride (Cl) concentration, the twins are formed during the copper electrodeposition, and chloride is incorporated in the twin boundaries to thereby increase the chloride content in the copper foil.

This electrolyte in the present invention is used at a solution temperature of 40 to 60°C and electrolyzed at a current density of 30 to 75 A/dm², preferably 40 to 70 A/dm2, more preferably 45 to 70 A/dm².

The electrodeposited copper foil containing the twins in high proportion can be obtained by the process using the above electrolyte. The obtained electrodeposited copper foil contains chloride in an amount of 50 to 180 ppm. In this electrodeposited copper foil, fine crystals or columnar crystals may be contained besides the twins. In this connection, when an electrolyte having a chloride (Cl) ion concentration of 10 to 300 ppm as employed in the afore-said Japanese Patent Application Publication (Unexamined) No. Hei 10-330983 is used, the crystals of the obtained copper foil would be columnar. On the other hand, when a copper foil was produced from an electrolyte having a chloride (Cl) ion concentration of less than 1 ppm as described in the afore-said Japanese Patent Application Publication (Unexamined) No. Hei 7-188969, only the fine crystals, without any twins, would be found in the obtained copper foil.

The crystal structure can be identified by preparing a copper foil specimen for cross section observation by means of a focused ion beam (FIB) and thereafter performing a scanning ion image microscope (SIM) observation on the specimen.

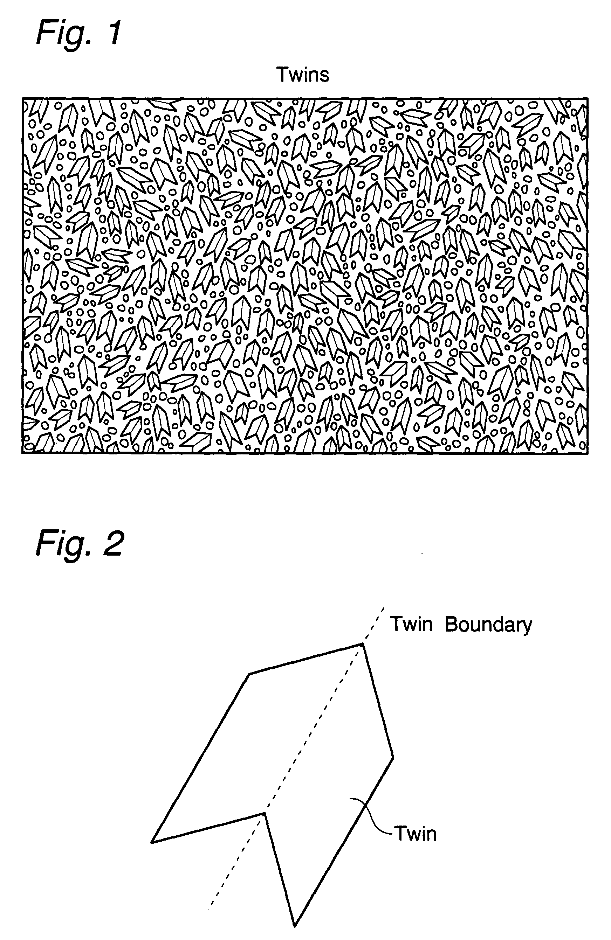

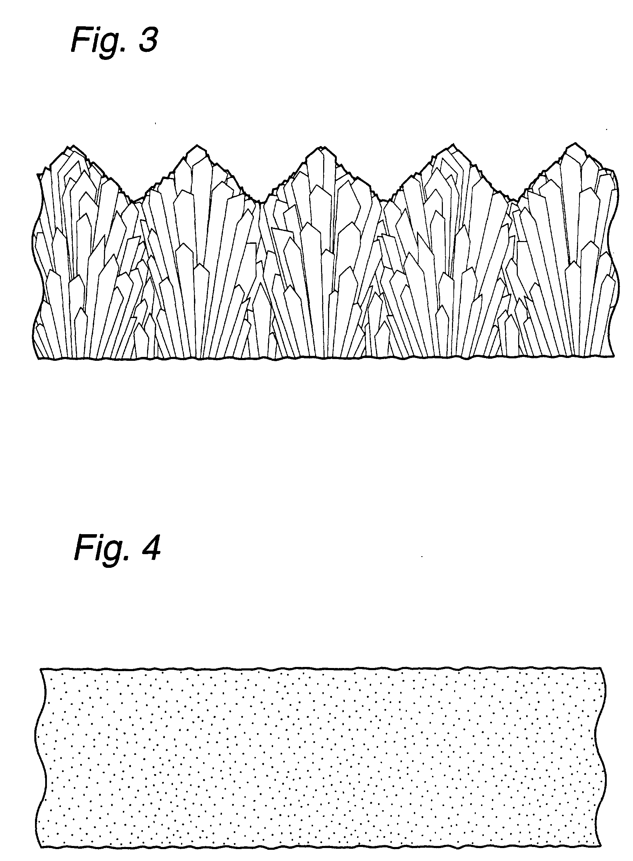

The twins, referring to Fig. 1, are formed by repeating that, upon advance of deposition and growth to a certain extent, the orientations of crystal structure are suddenly changed and subsequently new crystals grow. In the twins, two crystals contact each other while maintaining a fixed crystallographic relationship as shown in Fig. 2. On the other hand, the columnar crystals are formed by the deposition and growth of crystals in one direction as shown in Fig. 3. Further, referring to Fig. 4, the fine crystals are formed by the deposition of crystals of minute diameters with random orientation.

Not only the twins but also the fine crystals or columnar crystals are contained in the electrodeposited copper foil of the present invention.

The chloride content in the electrodeposited copper foil deposited from the electrolyte according to the present invention is 50 to 180 ppm as mentioned above. This chloride content is about 4 to 20 times that of the electrodeposited copper foil (crystals consisting only of columnar crystals) produced from an electrolyte having a chloride (Cl) ion concentration of 10 to 50 ppm or that of the copper foil (crystals consisting of fine crystals) produced from an electrolyte having a chloride (Cl) ion concentration of less than 1 ppm. Thus, it is apparent that chloride is incorporated much in the twins, especially at the twin boundary.

The chloride (ppm) incorporated in the electrodepostied copper foil of the present invention is 40 to 150 times, preferably 40 to 140 times, more preferably 50 to 130 times that of chloride ion concentration (ppm) in the electrolyte.

The above process of the present invention enables obtaining the electrodeposited copper foil having twins in which chloride is incorporated. The obtained electrodeposited copper foil, as aforementioned, exhibits excellent performance, such as, high tensile strength and large elongation at an elevated temperature.

Further, the above process of the present invention facilitates controlling the chloride concentration of the electrolyte without the need to add a large amount of chloride compound or an additive such as thiourea or amine compounds, so that the electrodeposited copper foil can be produced with high efficiency. In this connection, when thiourea was added to the electrolyte as in the Japanese Patent Application Publication (Unexamined) No. Hei 10-36992, it might occur that sulfur is incorporated in the copper foil, so that not only do the crystals of the obtained electrodeposited copper foil have a fine grain but also the amount of chloride incorporated in the crystals becomes small to thereby decrease the elongation of the copper foil.

The thickness and surface roughness (profile) of the electrodeposited copper foil produced by the above process of the present invention are appropriately selected depending on the usage of the electrodeposited copper foil. When the thicker electrodeposited copper foil is produced, the rotating speed of the cylindrical cathode drum in the electroforming cell is preferably decreased.

The surface roughness (Rz) of the matte side of the electrodeposited copper foil produced by the above process of the present invention is 2.0 to 5.0 µm, preferably 2.4 to 4.5 µm, more preferably 2.5 to 4.3 µm, and most preferably 2.5 to 3.2 µm.

The obtained electrodeposited copper foil of the present invention is suitable for use as a copper foil in the production of excellent printed wiring boards.

That is, a copper-clad laminate can be produced by laminating at least one side of an insulating substrate with the electrodeposited copper foil produced in the above manner. Further, a printed wiring board can be produced by forming a desirable pattern on the thus obtained copper-clad laminate by exposing and developing a photoresist and etching the electrodeposited copper foil of the copper-clad laminate masked with the etching resist. Moreover, a multilayer printed wiring board can be produced by uniting the thus produced printed wiring boards arranged one upon another while forming wiring patterns in the same manner as mentioned above.

Further the thus obtained electrodeposited copper foil of the present invention may be used as a collector for secondary battery such as lithium ion secondary battery.

Prior to the use of the thus produced electrodeposited copper foil, it is preferred that, if necessary, a nodulous copper be formed on the surface of the matte side (rough side, side finished with copper electrodeposition) of the electrodeposited copper foil. The treatment for forming this nodulous copper is referred to as "nodulation" or "roughening treatment".

The nodulation is a treatment comprising arranging the electrodeposited copper foil to face the matte side (rough side) to an anode and depositing copper on the matte side in a plating solution containing copper ions. In this nodulation, generally, a burn plating, a seal (covering) plating and a whisker plating are performed in sequence.

The burn plating, for example, comprises arranging the electrodeposited copper foil produced in the above manner so as to make the matte side (rough side) thereof to face an anode and plating copper on the matte side under the following conditions:
copper concentration of solution: 5 to 30 g/liter,
concentration of sulfuric acid in solution: 50 to 150 g/liter,
temperature of solution: 20 to 30°C,
current density: 20 to 40 A/dm², and
plating time: 5 to 15 sec.

As a result of this plating on the matte side of the electrodeposited copper foil under the above conditions, a twiglike copper electrodeposit called "burnt deposit" is formed on the matte side (rough side).

The matte side having undergone the burn plating is subjected to the seal plating. The seal plating, for example, comprises further plating copper on the matte side of the electrodeposited copper foil, having undergone the above burn plating, under the following conditions:
copper concentration of solution: 40 to 80 g/liter,
concentration of sulfuric acid in solution: 50 to 150 g/liter,
temperature of solution: 45 to 55°C,
current density: 20 to 40 A/dm², and
plating time: 5 to 15 sec.

As a result of the seal plating on the matte side of the delectrodeposited copper foil, a nodulous deposit of copper is formed on the matte side having "burnt deposit."

The surface of the matte side having undergone the seal plating under the above conditions may further be subjected to the whisker plating. The whisker plating, for example, comprises further plating copper on the matte side, having undergone the above seal plating, under the following conditions:
copper concentration of solution: 5 to 30 g/liter,
concentration of sulfuric acid in solution: 30 to 60 g/liter,
temperature of solution: 20 to 30°C,
current density: 10 to 40 A/dm², and
plating time: 5 to 15 sec.

As a result of the whisker plating on the matte side, having undergone the seal plating under the above conditions, whiskerlike copper is formed on the covering plating layer (coating layer of copper).

When the electrodeposited copper foil is used as a collector for secondary battery, the above "nodulation" or "roughening treatment" is not necessarily required. The electrodeposited copper foil which has small difference of the surface roughness (Rz) between matte side and shiny side is preferably used as a collector for secondary battery.

The thus nodulated or roughened electrodeposited copper foil is preferably followed by passivation.

The passivation to be employed in the present invention is not particularly limited, and it may be, for example, a passivation plating such as zinc plating or tin plating. In such a passivation plating, e.g., a zinc plating, use is made of an electrolyte in which zinc sulfate, zinc pyrophosphate or the like is dissolved.

After the passivation plating, the surface having undergone the passivation plating is preferably treated with chromate. In this chromate treatment, generally, the electrodeposited copper foil having undergone the passivation plating is immersed in a solution containing 0.2 to 5 g/liter of chromic anhydride and having a pH value adjusted to 9-13, and the matte side of the electrodeposited copper foil is treated at a current density of 0.1 to 3 A/dm². The period of treatment is generally about 1 to 8 sec.

After the chromate treatment, the surface of the electrodeposited copper foil is preferably treated with a silane coupling agent.

In this silane coupling agent treatment, generally, use is made of any of silane coupling agents such as an epoxyalkoxysilane, an aminoalkoxysilane, a methacryloxyalkoxysilane and a mercaptoalkoxysilane. These silane coupling agents can be used either individually or in combination. These silane coupling agents are applied to the surface of the electrodeposited copper foil in an amount of 0.15 to 20 mg/m², preferably 0.3 to 2.0 mg/m², in terms of silicon atom.

The electrodeposited copper foil having undergone the above nodulation or roughening treatment, passivation, plating, chromate treatment and silane coupling agent treatment is especially useful as a copper foil for printed wiring formation.

### Electrodeposited Copper Foil

In the electrodeposited copper foil of the present invention, chlorine or chloride ion is incorporated in the range of 50 ppm to 180 ppm.

The electrodeposited copper foil of the present invention comprises:
twins with
fine crystals and/or columnar crystals,
chlorine or chloride ion selectively incorporated in the twins, especially at the twin boundary, at the high content.

The crystal structure can be identified by preparing a copper foil specimen by means of a focused ion beam (FIB) and thereafter performing a scanning ion microscope (SIM) observation of the copper foil cross section.

The twins, referring to Fig. 1, are formed by repeating that, upon advance of deposition and growth to a certain extent, the orientations of crystal structure are suddenly changed and subsequently a new grain is grown. In the twins, two crystal solids contact each other while maintaining a fixed crystallographic relationship as shown in Fig. 2. On the other hand, the columnar grain is formed by the deposition and growth of crystals in one direction as shown in Fig. 3. Further, referring to Fig. 4, the fine grain is formed by the deposition of crystals of minute diameters without any orientation.

Not only the twins but also the fine crystals or columnar crystals are contained in the electrodeposited copper foil of the present invention.

At room temperature, this electrodeposited copper foil has a tensile strength of 45 to 65 kg/mm², preferably 45 to 63 kg/mm², more preferably 50 to 62 kg/mm², and an elongation of about 3 to 18 %, preferably 3 to 15 %, more preferably 6 to 15 %.

The thickness and surface profile of the electrodeposited copper foil of the present invention are appropriately selected depending on the usage of the electrodeposited copper foil.

Surface roughness (Rz) of the electrodeposited copper foil of the present invention is preferably in the range of 2.0 to 5.0 µm, more preferably 2.4 to 4.4 µm.

The above electrodeposited copper foil of the present invention, because of the high tensile strength and large elongation, is suitable for use as a copper foil for printed wiring applications or as a collector for secondary battery such as lithium ion secondary battery.

The electrodeposited copper foil of the present invention can be produced by, for example, the above-mentioned process.

### Copper-clad Laminate and Printed Wiring Board Therefrom

The copper-clad laminate can be produced by laminating, on at least one surface of an insulating substrate, the above electrodeposited copper foil with the use of an insulating adhesive or, without the use of adhesives, by hot press.

Resin substrates commonly used in electronic equipments can be employed as the insulating substrate of the copper-clad laminate. For example, use can be made of a paper/phenolic substrate, a paper/epoxy substrate, a glass/epoxy substrate and a polyimide substrate.

The printed wiring board can be produced by first applying, for example, a photoresist to the copper foil surface of the thus obtained copper-clad laminate, subsequently exposing and developing the photoresist to thereby form a desired etching resist pattern and thereafter etching the electrodeposited copper foil. Then, the surface of the insulating substrate is overlaid with a wiring pattern resulting from the etching of the copper foil.

Furthermore, the thus obtained printed wiring board comprising the insulating substrate having its surface overlaid with the wiring pattern resulting from the etching of the copper foil can be further laminated through an insulating layer with the electrodeposited copper foil, and this electrodeposited copper foil can be etched in the same manner to thereby form a multilayer printed wiring board.

### EFFECT OF THE INVENTION

The electrodeposited copper foil that is excellent in mechanical properties such as tensile strength and elongation can be produced by the use of an electrolyte having a chloride (Cl) ion concentration of 1 to 3 ppm, a copper concentration of 60 to 85 g/lit., a free sulfuric acid concentration of 100 to 250 g/lit. and a gelatin additive concentration of 0.3 to 5 ppm, and electrolyzing at 40 to 60 °C and at a current density of 30 to 75 A/dm² according to the process of the present invention. The thus obtained electrodeposited copper foil is especially suitable for use as a copper foil for printed wiring board or as a collector for the secondary battery such as lithium ion secondary battery.

The electrodeposited copper foil of the present invention is excellent in properties such as tensile strength and elongation. The electrodeposited copper foil is especially suitable for use as a copper foil for printed wiring application or as a collector for the secondary battery such as lithium ion secondary battery.

### EXAMPLE

The present invention will now be illustrated in more detail with reference to the following Examples, which in no way limit the scope of the invention.

### EXAMPLE 1

### Production of Electrodeposited Copper Foil

An electrolyte (solution temperature: 50°C) containing copper ions and free sulfuric acid in respective concentrations of 80 g/lit. and 250 g/lit. and further containing chloride (Cl) ions and gelatin in respective amounts of 2.7 ppm and 2 ppm was continuously fed into electroforming cell 4 as shown in Fig. 5. Copper was deposited (precipitated) on the surface of the cathode drum 1 at a current density of 60 A/dm². The copper was continuously released from the cathode drum 1 to thereby obtain 35 µm thick electrodeposited copper foil.

The tensile strength, elongation, surface profile on the copper foil deposition side (matte side) and chloride content of the obtained copper foil were measured.

The results are shown in Table 1.

The crystal structure of the obtained copper foil was evaluated by scanning ion image microscope (SIM) observation. As a result, it was found that twins are contained in large proportion.

### EXAMPLES 2-3 AND COMPARATIVE EXAMPLES 1-3

Electrodeposited copper foils were produced and evaluated in the same manner as in Example 1 except that the chloride (Cl) ion concentration of the employed electrolyte was changed as indicated in Table 1.

The results are also shown in Table 1.

**Table 1**

| | Cl concn. of electrolyte (ppm) | Tensile strength (kg/mm²) | Elongation (%) | Surface roughness of matte side (R_{z}) (µm) | Crystal structure of copper | Cl content of copper foil (ppm) | Cl content of copper foil/Cl ion concn. of electrolyte |
|---|---|---|---|---|---|---|---|
| Ex. 1 | 2.7 | 61.7 | 7.1 | 4.32 | twin crystal + columnar crystal | 110 | 40.7 |
| Ex. 2 | 1.5 | 52.3 | 11.5 | 3.14 | twin crystal + fine crystal | 180 | 120 |
| Ex. 3 | 1.1 | 55.2 | 8.3 | 2.74 | twin crystal + fine crystal | 66 | 60 |
| Comp. Ex. 1 | 0.6 | 53.7 | 6.3 | 3.26 | fine crystal | 23 | 38 |
| Comp. Ex. 2 | 0.2 | 49.3 | 6.5 | 6.84 | fine crystal | 17 | 85 |
| Comp. Ex. 3 | 20 | 35.0 | 7.1 | 8.32 | columnar crystal | 7 | 0.35 |

As apparent from Table 1, the electrodeposited copper foil having high tensile strength and excellent elongation can be obtained by regulating the chloride (Cl) ion concentration of the electrolyte to 1-3 ppm.

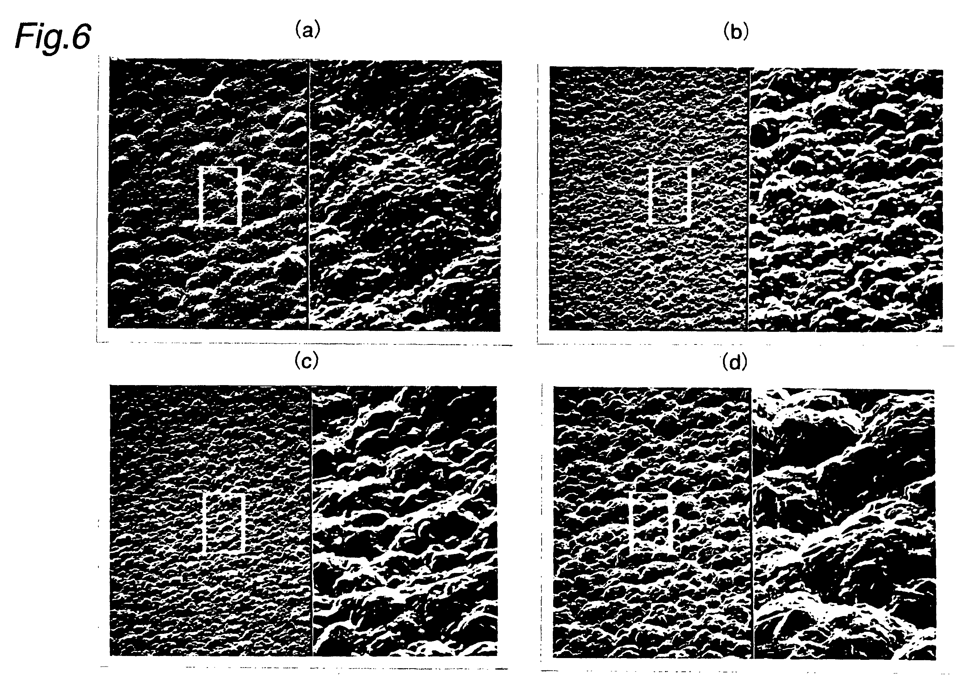

Fig. 6, (a) to (d) are phtographs by the scanning electron microscope of the electrodeposited copper foil produced in the same manner as in Example 1 except that chloride ion concentration of the electrolyte was changed. Fig. 6 (a) shows the electrodeposited copper foil obtained by using the electrolyte having the chloride ion concentration of 0.8 ppm, Fig. 6 (b) shows that of using the chloride ion concentration of 1.2 ppm, Fig. 6 (c) shows that of using the chloride ion concentration of 2.8 ppm, and Fig 6 (d) shows that of using the chloride ion concentration of 3.2 ppm, respectively.

As is clear from these Fig 6, the electrodeposited copper foils of the present invention have smooth surface as shown in Fig. 6(b) and (c). On the other hand, the electrodeposited copper foils obtained by using the electrolyte having the chloride ion concentration of smaller than 1 ppm or higher than 3 ppm, have many conical roughness as shown in Fig.6 (a) and (d).

## Claims

1. A process for producing an electrodeposited copper foil, comprising the steps of:
preparing an electrolyte having a copper concentration of 60 to 85 g/lit., a free sulfuric acid concentration of 100 to 250 g/lit., a chloride (Cl) ion concentration of 1 to 3 ppm and a gelatin additive concentration of 0.3 to 5 ppm and
electrolyzing at 40 to 60°C and at a current density of 30 to 75 A/dm² to thereby electrodeposit a copper foil.

2. The process of Claim 1, wherein said electrodeposited copper foil comprising:
twins with
fine crystals and/or columnar crystals, and
the chloride (Cl) ion or chlorine incorporated in the twins so that the chlorine content of the electrodeposited copper foil is in the range of 50 ppm to 180 ppm, and 40 to 150 times that of chloride ion concentration in the electrolyte.

3. The process of claim 1, wherein surface roughness (Rz) of matte side of said electrodeposited copper foil is in the range of 2.0 µm to 5.0 µm.

4. An electrodeposited copper foil comprising:
twins with
fine crystals and/or columnar crystals, and
chlorine (or chloride ion) incorporated in the twins so that the chlorine content of the electrodeposited copper foil is in the range of 50 ppm to 180 ppm, and 40 to 150 times that of chloride ion concentration in the electrolyte.

5. A copper-clad laminate comprising an insulating substrate having at least one side thereof laminated with the electrodeposited copper foil of Claim 4.

6. A printed wiring board furnished with desirable wiring pattern, produced by etching at its electrodeposited copper foil on a copper-clad laminate of Claim 5.
